# EUROPEAN PATENT APPLICATION

(11) **EP 4 310 514 A1**
(43) Date of publication of application: **24.01.2024**
(21) Application number: 21925533.8
(22) Date of filing: 10.02.2021
(51) Int. Cl.: G01R 19/00, G01R 22/06

(54) **DEVICE FOR THE MEASUREMENT OF POWER IN ELECTRICAL PROTECTION PANELS IN BUILDINGS, BY MEANS OF TEMPERATURE MEASUREMENT**

(71) Applicant: STEMY ENERGY, S.L., 28020 Madrid (ES)
(72) Inventor: SANCHEZ MIRALLES, Alvaro, 28020 Madrid (ES); BOAL MARTIN-LARRAURI, Jaime, 28023 Madrid (ES); MARTIN MARTINEZ, Francisco María, 28015 Madrid (ES); MARTIN LOPO, Miguel Manuel, 28015 Madrid (ES); VAZQUEZ BLANCO, Antonio, 27500 Chantada (ES); RODRIGUEZ - MORCILLO GARCIA, Carlos, 28023 Madrid (ES)
(74) Representative: González-Mogena González, Inigo
(86) International application number: PCT/ES2021/070091
(87) International publication number: WO 2022/171908

(57) **Abstract**

The present invention discloses a design for a measurement device (I) with improved power measurement accuracy, involving the measurement ofthe temperature using a highly accurate device that can be installed coupled to the protectors, the device (I) comprising: an essentially rectangular parallelepiped-shaped casing with a plurality of slots (2) in the lateral surfaces, one or more openings (3), and at least one electrical connection rod (4); a motherboard (PCB) on the inside ofthe casing, comprising a first face (20) having at least one Shunt resistor (5) and its own power supply (10), anda second face (30), opposite the first face (20), having a communication module consisting of a microcontroller (7) that is connected to the measurement module (6), -a temperature sensor

## Description

### OBJECT OF THE INVENTION

The object of the invention is a design of a device for measuring power in electrical protection panels in buildings by means of temperature measurement, which takes up little space and can be installed coupled to the protectors. The device allows for breaking down the demand, which is the basis for the creation of smart systems in buildings and, more critically, in the residential sector.

### BACKGROUND OF THE INVENTION

The measurement of electrical variables in household and industrial installations is of crucial importance, not only to maintain safety in an electrical installation but also to control consumption and the use of certain parts of an installation. Saving energy, improving the energy efficiency of energy consumption and reducing greenhouse gas emissions (GHG) are key initiatives in many cities and towns as well as for buildings owners and operators. To reduce energy consumption in buildings, it is essential to understand energy use patterns, the characteristics of building structures, operations and the behavior of the occupants who influence energy consumption. However, building structures often have different features, such as each one being built with unique features and designs or being different from one other. Due to this heterogeneity in buildings, analyzing energy consumption in buildings is not an easy or simple task.

In the state of the art, there are network analyzers to measure and control the electrical variables in an installation. These analyzers, however, have the drawback that they are very voluminous and generally very expensive as well as complex to install for multiple measurements, such as for their use in households or in large electrical panels that allow for multiple readings. And all this in view of allowing families and resident communities to control in a comprehensive and personalized manner the power consumption and electrical variables that affect an installation.

It may be desirable to exercise control by means of a power meter that can be placed high on a building's wiring hierarchy (e.g., at the point where the network wiring enters the building) and the power meter can be used to monitor the total energy consumption of the building.

However, said power meter located high on a building's wiring hierarchy for utilities might not be able to monitor the energy consumption of the different energy-consuming devices in the building. In other words, such a power meter might not be able to distinguish and/or separately monitor the energy consumption of different types of energy-consuming devices in the building.

A non-invasive load monitoring device can be placed high on a building's wiring hierarchy for utilities to distinguish and/or separately monitor the energy of different types of energy-consuming devices in the building. The different types of energy-consuming devices may have different energy consumption signatures associated with the same, and the device may detect changes in the energy signal through the building's wiring hierarchy for utilities, which correspond to the different energy consumption signatures of the different types of energy-consuming devices in the building. Depending on the changes detected in the supply signal, the device can determine the type of devices in the building that are consuming energy.

However, the devices may not be able to control the energy consumption of the individual energy-consuming devices of a substantially similar type and/or have substantially similar energy consumption signatures in the building. In other words, if the building includes multiple energy-consuming devices of a substantially similar type and/or having substantially similar energy consumption signatures, the device might not be able to distinguish one from another and/or separately monitor their energy consumption.

Spanish utility model E1185959 discloses a device for measuring electrical variables in electrical panels that is easy to install and very versatile, for household and/or industrial measuring of electrical currents and/or voltages in switches and protection devices for electrical panels. Furthermore, the device allows electrical variables and consumption and network quality statistics to be calculated from the measurements taken in the connection between the switches and/or protection devices for the electrical panel and the electrically-conducting power wires. The device comprises a housing made of an electrically insulating material, characterized in that it comprises: a printed circuit board, PCB, inside the housing, wherein the PCB incorporates a microprocessor and an electrical current sensor; a female connector and a male connector in the housing, the female connector and the male connector being electrically connected to one another; a communications terminal with remote control equipment; wherein the device is configured to: connect an electrically-conducting power wire of a power circuit to the female connector of the housing; connect the male connector of the housing to the connecting opening of protection equipment of an electrical panel; measure the intensity of the electrical current flowing through the wire, and; process and digitalize the measurement of the intensity of the electrical current flowing through the wire, and transmit it to the remote control equipment through the communication terminal.

One of the problems from the preceding document is the low accuracy in the measurements taken, since the temperature generated in the device is not taken into account. As is known, temperature variations in electrical current measuring apparatuses considerably influence the obtained results and the arrangement of the elements the PCB is composed of is not taken into account. In this case, the design incorporates the current sensor inside the PCB, such that high amperages through the device generate enough heat so as to affect the measurements obtained by the device.

The present invention satisfactorily resolves the previous problems, since the current and voltage measurements are taken by a shunt resistor arranged in such a manner that the temperature of the measuring device does not increase. In the preceding case, a current sensor and not a shunt resistor is incorporated, thus making its incorporation into the PCB necessary and, therefore, a temperature increase grows. In the present invention, the device incorporates a temperature sensor that allows the temperature to be controlled and compensated in the measurements. Furthermore, the arrangement of the other elements in the device minimizes the temperature changes, thus resulting in more accurate power measurements.

### DESCRIPTION OF THE DRAWINGS

To complement this description and for a greater understanding of the features of the invention in accordance with an exemplary preferred embodiment of the same, a set of drawings is attached as an integral part of said description, these drawings representing as follows merely for illustrative and non-limiting purposes:

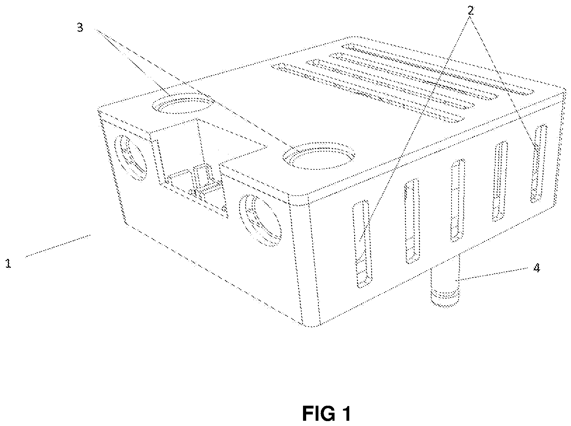

Figure 1.- shows a view of the housing of the device (1), its external elements and the protector (50) to which it is connected being indicated.

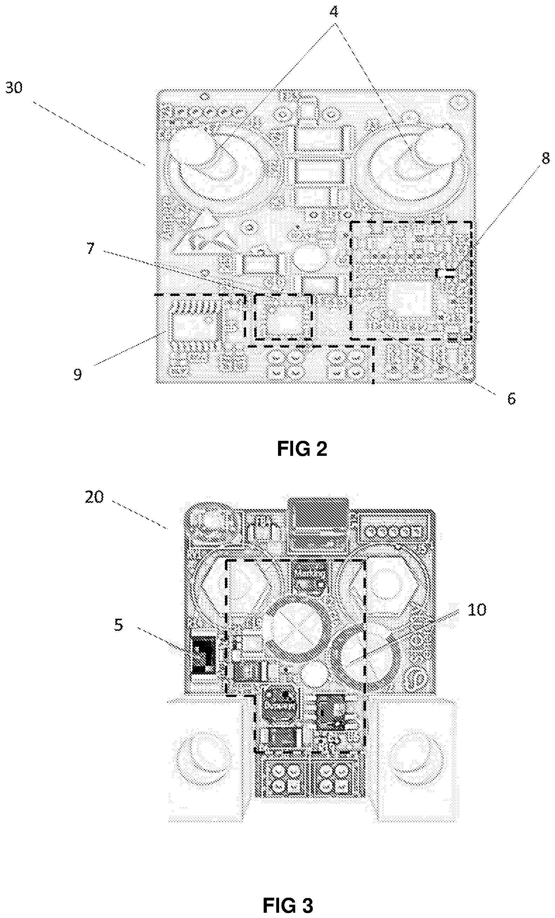

Figure 2.- shows a view of the board (PCB) (30) in which the essential elements, in particular the temperature sensor (8), are indicated.
Figure 3.-shows a view of the board (20) in which the location of the shunt resistor (5) is shown.

### BRIEF DESCRIPTION OF THE INVENTION

The device of the invention allows the electricity consumption to be measured directly through its direct connection to the lead-in and exit wires of an electrical line and its related electrical protection, in an electrical panel. For this, the invention proposes a small measuring device, which is suitable to be installed in electrical protections, being arranged in the top or bottom free space existing between protections in said electrical panels.

The device of the invention preferably comprises a shunt resistor to obtain the measurement of the input current and voltage flowing into the electrical protection. This makes it possible to overcome the lack of accuracy of the measuring sensors usually utilized in this technical field, which are generally based on measuring consumption by magnetic means. The device for measuring electricity consumption can be applied to single-phase, two-phase or three-phase protections, by adapting its connections to this end.

The design of the device allows a shunt resistor to be connected to an electronic measuring module allowing for reading, processing and/or storing the information relating to the current and the voltage flowing through the electrical protection. Said electronic measuring module is connected to an electronic communications module, configured with wireless Internet connection means (for example, through a Wi-Fi access point), in such a manner that the data read, processed and/or stored by the measuring module are transmitted to one or more remote devices, via its wireless connection. In this case, preferably the obtained measured data are sent to a central server or to the cloud, where they are stored together with the data on electricity tariffs and the optimum management of air conditioning (heat pump, radiators, electrical boiler, ...), hot water (by electrical means), electrical energy storage, electrical household appliances (optional) is determined and processed by means of an algorithm.

The device has a temperature sensor, which determines the temperature of the device motherboard (PCB) and allows temperature compensation models to be carried out while measuring. This increases the accuracy of the device and the temperature sensor allows for the detection of potential problems anywhere in the panel, due to the fact that the entire panel is interconnected with heat-transmitting wires and, in the case of presence of a hot spot in the panel, this can be detected. Thereby, defects can be avoided, which could lead to a fire due to an excess temperature.

The device enables measurements of intensity, voltage, frequency, input active energy, output active energy, input active power and output active power, input reactive energy, output reactive energy, input reactive power and output reactive power.

### PREFERRED EMBODIMENT OF THE INVENTION

The device (1) for measuring power in electrical protection panels in buildings by means of temperature measurement of the present invention can be installed coupled to the protectors. The device allows for breaking down the demand, which is the basis for the creation of smart systems in buildings and, more critically, in the residential sector. The device features a small measuring design, which is suitable to be installed in electrical protections, being arranged in the top or bottom free space existing between protections in said electrical panels.

One of the most important features of the device relates to the temperature that is stored in the device, for a good accuracy of the current and voltage measurements being required to take the device's temperature into account, since, as it is known, temperature variations lead to false estimations of the electrical variables to be measured. Therefore, it is necessary to maintain the temperature under control all the time to avoid great variations. To solve this problem, the device of the present invention incorporates a temperature sensor on the motherboard. This allows temperature compensation models to be carried out while measuring. This increases the accuracy of the device. Furthermore, the arrangement of the elements the device is composed of, both faces of the board (PCB) being included, is very important, since it allows for the reduction of the resistance between the lead-in and exit connections of the device. This arrangement of the elements in the device increases accuracy and reliability of the obtained measurements.

The device (1) is composed of a substantially rectangular parallelepiped housing with a plurality of slots (2) in the side surfaces for the ventilation of the internal components, one or more openings (3) preferably made of aluminum, adapted to receive at least one phase wire or a neutral wire of an installation controlled by an electrical protector, at least one electrical connection rod (4) preferably made of aluminum configured to be directly coupled to the protector, wherein both the rods (4) and the openings (3) are made of aluminum to act as heat sinks and help extract the heat from inside towards the ambient and the surrounding elements. Furthermore, the openings (3) and/or the rods (4) of the device (1) are configured to be adapted to a single-phase, two-phase or three-phase protection.

The internal part of the housing of the device (1) incorporates a board (PCB) with a first face (20) comprising at least one shunt resistor (5) connected to the phase wire or to the neutral wire of the installation and to a measuring module (6) fitted with electronic means for the recording, processing and/or storing of information relating to the current and voltage of the phase wire or the neutral wire; and an own power supply (10) through a connection to the electrical protector and/or to the phase/neutral wires of the installation passing through said protector; a second face (30) opposite to the first face (20) comprising a communications module composed of a microcontroller (7) for data communication and processing, wherein said communications module is connected to the measuring module (6) and configured with electronic means for transmitting the recorded information to the communications ports (9); a temperature sensor (8) arranged on the side opposite to the shunt resistor (5) and very close to the same; electrically insulated communications ports (9), which send the information to other equipment that sends the information to the cloud; an analogue-to-digital converter allowing the signal phase deltas to be accurately calculated among the voltage and current measurements and which makes it possible to calculate with a high accuracy if the energy consumption or generation that can be accumulated for the total consumption of active and reactive energy and the generation is occurring.

The communications ports (9) are electrically insulated, so that a plurality of external devices can be connected to the same communications network regardless of the voltage of the lines that are measured. This allows for the utilization of the device in multiphase installations or the installation of devices with a switched polarity in the same communications network.

Although the design utilizes a shunt of an extremely low resistance (as low as the copper wire utilized for the electrical installation), the high current intensities through the device generate enough heat so as to be considered when the device (1) is designed. Therefore, the distribution of the elements on both faces of the motherboard (PCB) helps reduce the resistance between the lead-in and exit connections of the device when minimizing the length of the utilized copper pieces. A particularly high copper thickness is utilized when designing the motherboard (PCB) to help reduce the resistance.

The measuring accuracy is high and the physical circuit components behave in a different manner depending on the operating temperatures. The measurement of the temperature of the motherboard (PCB) by the temperature sensor (7) allows temperature compensation models to be carried out while measuring. This increases the accuracy of the device.

On the other hand, for the detection of failures, there is a strong correlation between the measured current and the temperature. Out-of-range temperatures may allow for an early detection of circuit failures such as a high resistance due to a bad contact of the wires with other installation elements. This can be used to warn users before failures occur.

For high accuracy measurements, the device (1) takes measurements both from voltage and current signals. Firstly, each signal is filtered out with a low-pass filter to avoid a frequency overlapping when the signal is converted into a digital measurement with an AD converter. For a higher accuracy near the zero-signal crossing, sigma-delta converters (analogue-digital) are utilized. Furthermore, this allows for an accurate calculation of the signal phase deltas among the voltage and current measurements. The real RMS (root mean square) values of each of the signals are calculated according to the AD converter values. This allows for an accurate calculation of the instantaneous power based upon the real RMS current, the real RMS voltage and the signal compensations. This allows to calculate with a high accuracy if the energy consumption or generation that can be accumulated for the total consumption of active and reactive energy and the generation is occurring.

It is important to take into account that combining a measuring method by means of a shunt resistor for the current signal and accurately monitoring the voltage signals makes high accuracy measurements possible even when the current signals are not sinusoidal.

The device (1) features a communications module to be connected to a server or the cloud, where the information on the electricity market and meteorology agencies (temperature, wind, solar radiation), information on the building (optional), information on the temperature from the inside, information relating to the user preferences on temperature (optionally preferences on luminosity) is combined. Therefore, the intelligence programmed in the server or the cloud determines the optimum management of air conditioning (heat pump, radiators, electrical boiler, etc.), hot water (heating by electrical means), electrical energy storage, electrical household appliances (optional).

Communication protocols of a low computational power with a network discovery are used for an easy installation of new devices to be possible in the same communications network. The communications network is periodically scanned searching for new devices not initialized. If found, an address is negotiated and assigned to these devices, which will form part of the network after that.

The reduced dimensions of the device make a relatively easy installation possible. Alternatively, the device can be manufactured to assign connecting wires on both ends (input and output) instead of using connection rods like in the described design.

## Claims

1. Device (1) for measuring power in electrical protection panels in buildings by means of temperature measurement, to be installed coupled to a protector **characterized in that** it comprises:
a substantially rectangular parallelepiped housing with a plurality of slots (2) in the side surfaces for the ventilation of the internal components, one or more openings (3) adapted to receive at least one phase wire or a neutral wire of an installation controlled by said protector, at least one electrical connection rod (4) configured to be directly coupled to the protector;
a motherboard (PCB) inside the housing comprising:
a first face (20) featuring at least one shunt resistor (5) connected to the phase wire or to the neutral wire of the installation and to a measuring module (6) fitted with electronic means for the recording, processing and/or storing of information relating to the current and voltage of the phase wire or the neutral wire; and an own power supply (10) through a connection to the electrical protector and/or to the phase/neutral wires of the installation passing through said electrical protector;
a second face (30) opposite to the first face (20) comprising: a communications module composed of a microcontroller (7) for data communication and processing, wherein said communications module is connected to the measuring module (6) and configured with electronic means for transmitting the recorded information to the communications ports (9); a temperature sensor (8) arranged on the second face (30) and on the side opposite to the shunt resistor (5); electrically insulated communications ports (9), which send the information processed or stored by the communications module (7) to other equipment that sends the information to the cloud; and
an analogue-to-digital converter allowing the signal phase deltas to be calculated among the voltage measurements.

2. The device (1) for measuring power in electrical protection panels in buildings by means of temperature measurement according to claim 1, **characterized in that** the openings (3) are preferably made of aluminum.

3. The device (1) for measuring power in electrical protection panels in buildings by means of temperature measurement according to claim 1, **characterized in that** the electrical connection rod(s) (4) are preferably manufactured in aluminum.

4. The device (1) for measuring power in electrical protection panels in buildings by means of temperature measurement according to claim 1, **characterized in that** the openings (3) and/or the rods (4) of the device (1) are configured to be adapted to a single-phase, two-phase or three-phase protection.

5. The device (1) for measuring power in electrical protection panels in buildings by means of temperature measurement according to claim 1, **characterized in that** the communications ports (9) allow a plurality of external devices to be connected to the same communications network regardless of the voltage of the lines that are measured.
